# EUROPEAN PATENT APPLICATION

(11) **EP 2 615 546 A1**
(43) Date of publication of application: **17.07.2013**
(21) Application number: 12828153.2
(22) Date of filing: 27.08.2012
(51) Int. Cl.: G06F 9/455, G06F 11/26

(54) **METHOD AND SYSTEM, SCHEDULER FOR PARALLEL SIMULATING PROCESSORS**

(30) Priority: 30.08.2011 CN 201110252377
(71) Applicant: Huawei Technologies Co., Ltd, Shenzhen, Guangdong 518129 (CN)
(72) Inventor: YE, Handong, Shenzhen Guangdong 518129 (CN); CAO, Jiong, Shenzhen Guangdong 518129 (CN); YE, Xiaochun, Shenzhen Guangdong 518129 (CN); WANG, Da, Shenzhen Guangdong 518129 (CN)
(74) Representative: Pfenning, Meinig & Partner GbR
(86) International application number: PCT/CN2012/080608
(87) International publication number: WO 2013/029513

(57) **Abstract**

The present invention provides a method, system, and scheduler for simulating multiple processors in parallel. The scheduler create one or more slave threads using a master thread, and determines a processor that is simulated by the master thread and a processor that is simulated by a slave thread, so that the scheduler is capable of using the master thread and the one or more slave threads to invoke, through a first execute interface, the determined processor that is simulated by the master thread and the determined processor that is simulated by the slave thread to execute a corresponding instruction, where the first execute interface is registered with the scheduler by the determined processor that is simulated by the master thread and the determined processor that is simulated by the slave thread. Because the master thread and the one or more slave threads are able to be used to schedule a processor that is simulated by the master thread and a processor that is simulated by a slave thread each time, multiple processors are able to be simulated in parallel. This avoids a problem in the prior art that multiple processors cannot be simulated in parallel because only one processor is scheduled each time, thereby increasing simulation efficiency; meanwhile, processor resources of a host where the scheduler is located are able to be fully utilized, thereby improving resource utilization.

## Description

### FIELD OF THE INVENTION

Embodiments of the present invention relate to a simulation technology, and in particular, to a method, system, and scheduler for simulating multiple processors in parallel.

### BACKGROUND OF THE INVENTION

An SIMICS simulator is a system simulator with high performance, which may simulate a single-processor system and a multi-processor system. When simulating the multi-processor system, the SIMICS simulator performs scheduling by adopting a single processor scheduling manner, that is, scheduling one processor each time to execute a corresponding instruction in order to simulate multiple processors in series.

However, because only one processor is scheduled each time, multiple processors cannot be simulated in parallel, resulting in a decrease of simulation efficiency.

### SUMMARY OF THE INVENTION

Embodiments of the present invention provide a method, system, and scheduler for simulating multiple processors in parallel, in order to increase simulation efficiency.

In one aspect, a method for simulating multiple processors in parallel is provided, including:
creating, by a scheduler, one or more slave threads using a master thread, and determining and obtaining a processor that is simulated by the master thread and a processor that is simulated by a slave thread; and
using, by the scheduler, the master thread and the one or more slave threads to invoke, through a first execute interface, the determined processor that is simulated by the master thread and the determined processor that is simulated by the slave thread to execute a corresponding instruction, where the first execute interface is registered with the scheduler by the determined processor that is simulated by the master thread and the determined processor that is simulated by the slave thread.

In another aspect, a scheduler is provided, including:
a creating unit, configured to create one or more slave threads using a master thread, and determine and obtain a processor that is simulated by the master thread and a processor that is simulated by a slave thread; and
an invoking unit, configured to use the master thread and the one or more slave threads that are created by the creating unit to invoke, through a first execute interface, the processor that is simulated by the master thread and determined by the creating unit and the processor that is simulated by the slave thread and determined by the creating unit to execute a corresponding instruction, where the first execute interface is registered with the scheduler by the determined processor that is simulated by the master thread and the determined processor that is simulated by the slave thread.

In still another aspect, a system for simulating multiple processors in parallel is provided, including a processor that is simulated by a master thread and a processor that is simulated by a slave thread and further including the foregoing scheduler.

As can be known from the foregoing technical solutions, in embodiments of the present invention, the scheduler creates one or more slave threads using a master thread, and determines a processor that is simulated by the master thread and a processor that is simulated by a slave thread, so that the scheduler is capable of using the master thread and the one or more slave threads to invoke, through the first execute interface, the determined processor that is simulated by the master thread and the determined processor that is simulated by the slave thread to execute a corresponding instruction, where the first execute interface is registered with the scheduler by the determined processor that is simulated by the master thread and the determined processor that is simulated by the slave thread. Because the master thread and the one or more slave threads are able to be used to schedule a processor that is simulated by the master thread and a processor that is simulated by a slave thread each time, multiple processors are able to be simulated in parallel. This avoids a problem in the prior art that multiple processors cannot be simulated in parallel because only one processor is scheduled each time, thereby increasing the simulation efficiency; meanwhile, processor resources of a host where the scheduler is located are able to be fully utilized, thereby improving resource utilization.

### BRIEF DESCRIPTION OF THE DRAWINGS

To make technical solutions in the embodiments of the present invention or in the prior art clearer, the accompanying drawings used in the description of the embodiments or the prior art are briefly described below. Evidently, the accompanying drawings illustrate some exemplary embodiments of the present invention and persons of ordinary skill in the art may obtain other accompanying drawings based on these accompanying drawings without creative efforts.

FIG. 1 is a schematic flowchart of a method for simulating multiple processors in parallel according to an embodiment of the present invention;

FIG. 2 is a schematic flowchart of a method for simulating multiple processors in parallel according to another embodiment of the present invention;

FIG. 3 is a schematic diagram of system architecture which the embodiment corresponding to FIG. 2 is applicable to;

FIG. 4 is a schematic structural diagram of a scheduler according to another embodiment of the present invention;

FIG. 5 is a schematic structural diagram of a scheduler according to another embodiment of the present invention; and

FIG. 6 is a schematic structural diagram of a system for simulating multiple processors in parallel according to another embodiment of the present invention.

### DETAILED DESCRIPTION OF THE EMBODIMENTS

To make the objectives, technical solutions, and advantages of the embodiments of the present invention clearer, the technical solutions in the embodiments of the present invention are described clearly and completely below with reference to the accompanying drawings. Evidently, the described embodiments are only some embodiments of the present invention, rather than all embodiments of the present invention. All other embodiments, which are able to be derived by persons of ordinary skill in the art from the embodiments in the present invention without any creative effort, shall fall within the protection scope of the present invention.

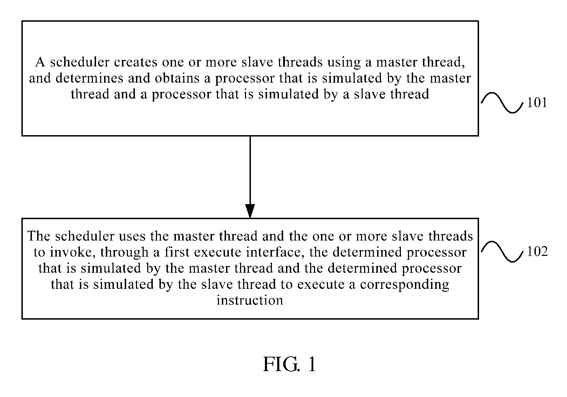

FIG. 1 is a schematic flowchart of a method for simulating multiple processors in parallel according to an embodiment of the present invention. As shown in FIG. 1, the method for simulating multiple processors in parallel in this embodiment may include the following steps:

101. A scheduler creates one or more slave threads using a master thread, and determines and obtains a processor that is simulated by the master thread and a processor that is simulated by a slave thread.

There is only one master thread, and the number of slave threads is at most equal to the number of processors of a host where the scheduler is located minus 1, so that each thread corresponds to one processor of the host.

Specifically, the scheduler may create, according to a configuration file, one or more slave threads using the master thread, and determine a processor that is simulated by the master thread and a processor that is simulated by a slave thread. The configuration file may include but is not limited to the number of created slave threads and a mapping relationship between a thread (the master thread or a slave thread) and the processor that is simulated by the thread.

102. The scheduler uses the master thread and the one or more slave threads to invoke, through a first execute interface (execute interface), the determined processor that is simulated by the master thread and the determined processor that is simulated by the slave thread so as to execute a corresponding instruction.

The first execute interface is registered with the scheduler by the determined processor that is simulated by the master thread and the determined processor that is simulated by the slave thread.

It is understandable that each thread may correspond to one processor that is simulated by the thread, or may correspond to multiple processors that are simulated by the thread, which is not limited in this embodiment. If each thread corresponds to multiple processors that are simulated by the thread, in step 102, each time when scheduling, through the master thread and a slave thread, the processor that is simulated by the master thread and the processor that is simulated by the slave thread to execute the corresponding instruction, the scheduler may first schedule one processor that is simulated by each thread in parallel, and then schedule, in series in each thread, other processors that are simulated by the thread.

Optionally, the instruction may include but is not limited to at least one of the following instructions: an instruction for accessing memory, which is used for indicating an instruction for accessing a same type of memory or different types of memory; and an instruction for accessing a peripheral, which is used for indicating an instruction for accessing a same peripheral or different peripherals.

Optionally, the instruction may also be an atomic instruction. In this case, in step 102, the scheduler may specifically use a mutex lock operation to invoke the determined processor that is simulated by the master thread and the determined processor that is simulated by the slave thread to execute the corresponding instruction.

Optionally, in this embodiment, the scheduler may further use the master thread and the one or more slave threads to assign, through a first cycle interface (cycle interface), a cycle parameter to the determined processor that is simulated by the master thread and the determined processor that is simulated by the slave thread, in order to control synchronous invoking between the determined processor that is simulated by the master thread and the determined processor that is simulated by the slave thread, thereby ensuring consistent scheduling of the determined processor that is simulated by the master thread and the determined processor that is simulated by the slave thread between threads, where the first cycle interface is registered with the scheduler by the determined processor that is simulated by the master thread and the determined processor that is simulated by the slave thread.

Optionally, the executor scheduler in steps 101 and 102 may be a scheduling unit in a SIMICS simulator.

Optionally, the executor scheduler in steps 101 and 102 may be an independently arranged controller unit. Further, the scheduler may register a corresponding second execute interface with the scheduling unit in the SIMICS simulator, so that the scheduling unit triggers, through the second execute interface, the scheduler to create one or more slave threads using the master thread. Accordingly, the scheduler may further register a corresponding second cycle interface with the scheduling unit in the SIMICS simulator, so that the scheduling unit uses the master thread to assign a cycle parameter to the scheduler through the second cycle interface, and thereby the scheduler uses the master thread and the one or more slave threads to assign, through the first cycle interface, the cycle parameter to the determined processor that is simulated by the master thread and the determined processor that is simulated by the slave thread, in order to control synchronous invoking between the determined processor that is simulated by the master thread and the determined processor that is simulated by the slave thread, where the first cycle interface is registered with the scheduler by the determined processor that is simulated by the master thread and the determined processor that is simulated by the slave thread.

In this embodiment, the scheduler creates one or more slave threads using the master thread, and determines a processor that is simulated by the master thread and a processor that is simulated by a slave thread, so that the scheduler is capable of using the master thread and the one or more slave threads to invoke, through the first execute interface, the determined processor that is simulated by the master thread and the determined processor that is simulated by the slave thread to execute the corresponding instruction, where the first execute interface is registered with the scheduler by the determined processor that is simulated by the master thread and the determined processor that is simulated by the slave thread. Because the master thread and one or more slave threads are able to be used to schedule a processor that is simulated by the master thread and a processor that is simulated by a slave thread each time, multiple processors are able to be simulated in parallel. This avoids a problem in the prior art that multiple processors cannot be simulated in parallel because only one processor is scheduled each time, thereby increasing simulation efficiency; meanwhile, processor resources of a host where the scheduler is located are able to be fully utilized, thereby improving resource utilization.

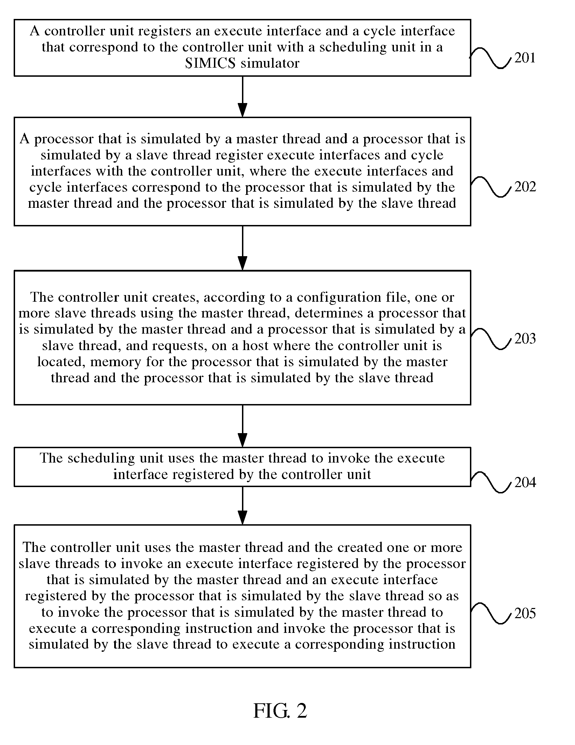

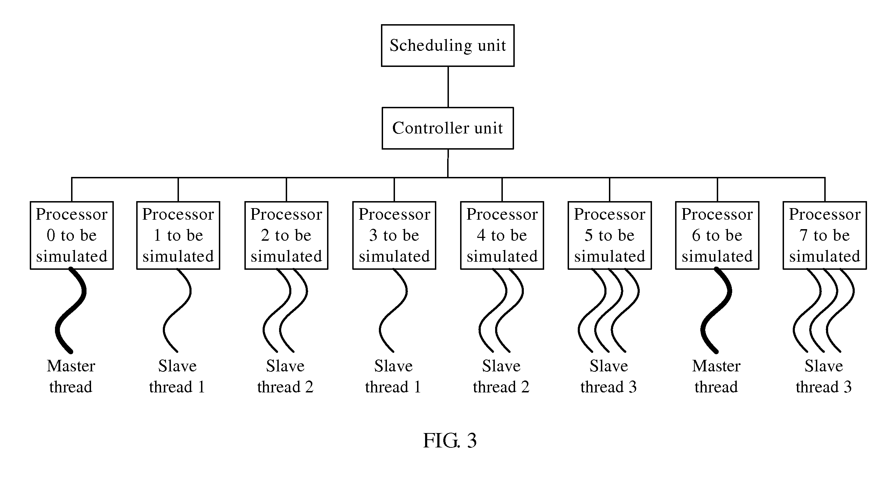

To make the method provided by this embodiment of the present invention clearer, the following takes that the executor scheduler in steps 101 and 102 is an independently arranged controller (Controller) unit as an example. FIG. 2 is a schematic flowchart of a method for simulating multiple processors in parallel according to another embodiment of the present invention, and system architecture which this embodiment is applicable to may be shown in FIG. 3. As shown in FIG. 2, the method for simulating multiple processors in parallel in this embodiment may include the following steps:

201. A controller unit registers an execute interface and a cycle interface that correspond to the controller unit with a scheduling unit in a SIMICS simulator.

202. A processor that is simulated by a master thread and a processor that is simulated by a slave thread register execute interfaces and cycle interfaces with the controller unit, where the execute interfaces and cycle interfaces correspond to the processor that is simulated by the master thread and the processor that is simulated by the slave thread.

203. The controller unit creates, according to a configuration file, one or more slave threads using the master thread, determines a processor that is simulated by the master thread and a processor that is simulated by a slave thread, and requests, on a host where the controller unit is located, memory for the processor that is simulated by the master thread and the processor that is simulated by the slave thread.

For example, the master thread corresponds to a processor 0 and a processor 6, where the processor 0 and the processor 6 are simulated by the master thread;
a slave thread 1 corresponds to a processor 1 and a processor 3, where the processor 1 and the processor 3 are simulated by the slave thread 1;
a slave thread 2 corresponds to a processor 2 and a processor 4, where the processor 2 and the processor 4 are simulated by the slave thread 2; and
a slave thread 3 corresponds to a processor 5 and a processor 7, where the processor 5 and the processor 7 are simulated by the slave thread 3.

Optionally, the controller unit may request, on the host where the controller unit is located, a same type of memory for the processor that is simulated by the master thread and the processor that is simulated by the slave thread, in order to simulate multiple processors to access the same type of memory, or may also request, on the host where the controller unit is located, different types of memory for the processor that is simulated by the master thread and the processor that is simulated by the slave thread, in order to simulate multiple processors to access different types of memory.

204. The scheduling unit uses the master thread to invoke the execute interface registered by the controller unit.

205. The controller unit uses the master thread and the created one or more slave threads to invoke an execute interface registered by the processor that is simulated by the master thread and an execute interface registered by the processor that is simulated by the slave thread so as to invoke the processor that is simulated by the master thread to execute a corresponding instruction and invoke the processor that is simulated by the slave thread to execute a corresponding instruction.

For example, the controller unit uses the master thread to invoke an execute interface registered by the processor 0 that is simulated by the master thread and then invoke an execute interface registered by the processor 6 that is simulated by the master thread;
the controller unit uses the slave thread 1 to invoke an execute interface registered by the processor 1 that is simulated by the slave thread 1 and then invoke an execute interface registered by the processor 3 that is simulated by the slave thread 1;
the controller unit uses the slave thread 2 to invoke an execute interface registered by the processor 2 that is simulated by the slave thread 2 and then invoke an execute interface registered by the processor 4 that is simulated by the slave thread 2; and
the controller unit uses the slave thread 3 to invoke an execute interface registered by the processor 5 that is simulated by the slave thread 3 and then invoke an execute interface registered by the processor 7 that is simulated by the slave thread 3.

Optionally, in step 204, the scheduling unit may further use the master thread to invoke the cycle interface registered by the controller unit to assign a cycle parameter to the controller unit, so that the controller unit further uses the master thread and the created one or more slave threads to invoke a cycle interface registered by a processor simulated by a thread so as to assign a target value of time advance to the processor simulated by the thread, in order to control synchronous invoking between the processor that is simulated by the master thread and the processor that is simulated by the slave thread. For example, the cycle parameter may be a processor-switch-time parameter (for example, a cpu-switch-time parameter), which is used for indicating the specified number of instructions to be executed. For example, after executing the specified number of instructions, the processor that is simulated by the slave thread notifies the controller unit on the master thread and enters a sleep state; after receiving notifications of processors that are simulated by all slave threads, the controller unit on the master thread exits the execute interface and waits for re-executing step 204.

In this embodiment, after being invoked by the scheduling unit in the SIMICS simulator, the controller unit creates one or more slave threads using the master thread, and determines a processor that is simulated by the master thread and a processor that is simulated by a slave thread, so that the controller unit is capable of using the master thread and the one or more slave threads to invoke, through a first execute interface, the determined processor that is simulated by the master thread and the determined processor that is simulated by the slave thread to execute a corresponding instruction, where the first execute interface is registered with the controller unit by the processor that is simulated by the master thread and the processor that is simulated by the slave thread. Because the master thread and one or more slave threads are able to be used to schedule a processor that is simulated by the master thread and a processor that is simulated by a slave thread each time, multiple processors are able to be simulated in parallel. This avoids a problem in the prior art that multiple processors cannot be simulated in parallel because only one processor is scheduled each time, thereby increasing simulation efficiency; meanwhile, processor resources of a host where the scheduler is located are able to be fully utilized, thereby improving resource utilization.

It should be noted that, for ease of description, the foregoing method embodiments are all described as a series of actions. Those skilled in the art should understand that the present invention is not limited to a sequence of actions described herein and that according to the present invention, and some steps may be performed in another sequence or at the same time. In addition, those skilled in the art should know that the embodiments described in the specification are exemplary embodiments and actions and modules involved in these embodiments are not mandatory for the present invention.

In the foregoing embodiments, each embodiment has its emphasis. What is not detailed in one embodiment of the present invention is detailed in the related description of another embodiment.

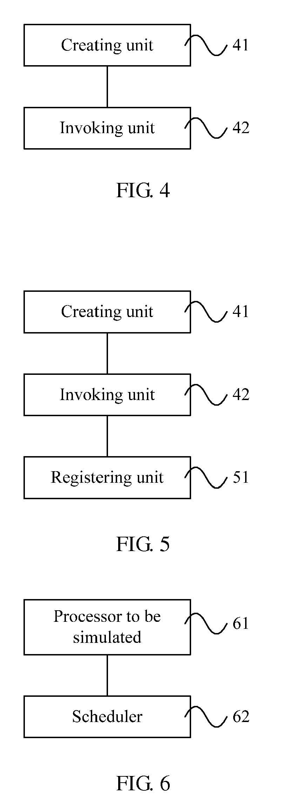

FIG. 4 is a schematic structural diagram of a scheduler according to another embodiment of the present invention. As shown in FIG. 4, the scheduler in this embodiment may include a creating unit 41 and an invoking unit 42. The creating unit 41 is configured to create one or more slave threads using a master thread, and determine and obtain a processor that is simulated by the master thread and a processor that is simulated by a slave thread; the invoking unit 42 is configured to use the master thread and the one or more slave threads that are created by the creating unit 41 to invoke, through a first execute interface, the processor that is simulated by the master thread and determined by the creating unit 41 and the processor that is simulated by the slave thread and determined by the creating unit 41 to execute a corresponding instruction, where the first execute interface is registered with the scheduler by the processor that is simulated by the master thread and determined by the creating unit 41 and the processor that is simulated by the slave thread and determined by the creating unit 41.

The function of the scheduler in the embodiment corresponding to FIG. 1 may be implemented by the scheduler provided by this embodiment.

Optionally, the corresponding instruction that the invoking unit 42 in this embodiment invokes the processor that is simulated by the master thread and determined by the creating unit 41 and the processor that is simulated by the slave thread and determined by the creating unit 41 to execute includes but is not limited to at least one of the following instructions: an instruction for accessing memory, which is used for indicating an instruction for accessing a same type of memory or different types of memory; and an instruction for accessing a peripheral, which is used for indicating an instruction for accessing a same peripheral or different peripherals.

Optionally, the corresponding instruction that the invoking unit 42 in this embodiment invokes the processor that is simulated by the master thread and determined by the creating unit 41 and the processor that is simulated by the slave thread and determined by the creating unit 41 to execute may also be an atomic instruction. In this case, the invoking unit 42 may specifically use a mutex lock operation to invoke the processor that is simulated by the master thread and determined by the creating unit and the processor that is simulated by the slave thread and determined by the creating unit to execute the corresponding instruction.

Optionally, the invoking unit 42 may further use the master thread and the one or more slave threads to assign, through a first cycle interface (cycle interface), a cycle parameter to the processor that is simulated by the master thread and determined by the creating unit 41 and the processor that is simulated by the slave thread and determined by the creating unit 41, in order to control synchronous invoking between the processor that is simulated by the master thread and determined by the creating unit 41 and the processor that is simulated by the slave thread and determined by the creating unit 41, thereby guaranteeing consistent scheduling of the processor that is simulated by the master thread and the processor that is simulated by the slave thread between threads, where the first cycle interface is registered with the scheduler by the processor that is simulated by the master thread and determined by the creating unit 41 and the processor that is simulated by the slave thread and determined by the creating unit 41.

Optionally, the scheduler provided in this embodiment may be a scheduling unit in a SIMICS simulator.

Optionally, the scheduler provided in this embodiment may be an independently arranged controller unit. Further, as shown in FIG. 5, the scheduler provided in this embodiment may also include a registering unit 51, configured to register a corresponding second execute interface with the scheduling unit in the SIMICS simulator, so that the scheduling unit triggers, through the second execute interface, the scheduler to create one or more slave threads using the master thread.

Accordingly, the registering unit 51 may further register a corresponding second cycle interface with the scheduling unit in the SIMICS simulator, so that the scheduling unit uses the master thread to assign a cycle parameter to the scheduler through the second cycle interface, and thereby the invoking unit uses the master thread and the one or more slave threads to assign, through the first cycle interface, the cycle parameter to the processor that is simulated by the master thread and determined by the creating unit 41 and the processor that is simulated by the slave thread and determined by the creating unit 41, in order to control synchronous invoking between the processor that is simulated by the master thread and determined by the creating unit 41 and the processor that is simulated by the slave thread and determined by the creating unit 41, where the first cycle interface is registered with the scheduler by the processor that is simulated by the master thread and determined by the creating unit 41 and the processor that is simulated by the slave thread and determined by the creating unit 41.

In this embodiment, in the scheduler, the creating unit creates one or more slave threads using the master thread, and determines a processor that is simulated by the mater thread and a processor that is simulated by a slave thread, so that the invoking unit is capable of using the master thread and the one or more slave threads to invoke, through the first execute interface, the processor that is simulated by the master thread and determined by the creating unit 41 and the processor that is simulated by the slave thread and determined by the creating unit 41 to execute the corresponding instruction, where the first execute interface is registered with the scheduler by the processor that is simulated by the master thread and determined by the creating unit 41 and the processor that is simulated by the slave thread and determined by the creating unit 41. Because the master thread and one or more slave threads are able to be used to schedule a processor that is simulated by the master thread and a processor that is simulated by a slave thread each time, multiple processors are able to be simulated in parallel. This avoids a problem in the prior art that multiple processors cannot be simulated in parallel because only one processor is scheduled each time, thereby increasing simulation efficiency; meanwhile, processor resources of a host where the scheduler is located are able to be fully utilized, thereby improving resource utilization.

FIG. 6 is a schematic structural diagram of a system for simulating multiple processors in parallel according to another embodiment of the present invention. As shown in FIG. 6, the system for simulating multiple processors in parallel in this embodiment may include a processor 61 to be simulated and a scheduler 62. The scheduler may be the scheduler provided by either of the embodiments corresponding to FIG. 4 and FIG. 5. Details are disclosed in the corresponding embodiments and not provided herein.

In this embodiment, the scheduler creates one or more slave threads using a master thread, and determines a processor that is simulated by the master thread and a processor that is simulated by a slave thread, so that the scheduler is capable of using the master thread and the one or more slave threads to invoke, through a first execute interface, the processor that is simulated by the master thread and determined by the scheduler and the processor that is simulated by the slave thread and determined by the scheduler to execute a corresponding instruction, where the first execute interface is registered with the scheduler by the processor that is simulated by the master thread and determined by the scheduler and the processor that is simulated by the slave thread and determined by the scheduler. Because the master thread and one or more slave threads are able to be used to schedule a processor that is simulated by the master thread and a processor that is simulated by a slave thread each time, multiple processors are able to be simulated in parallel. This avoids a problem in the prior art that multiple processors cannot be simulated in parallel because only one processor is scheduled each time, thereby increasing simulation efficiency; meanwhile, processor resources of a host where the scheduler is located are able to be fully utilized, thereby improving resource utilization.

It is understandable by those skilled in the art that for the specific working processes of the preceding system, apparatuses, and units, reference may be made to corresponding processes in the method embodiments, and no description is further provided herein.

It should be understandable that in the embodiments of the present invention, the disclosed system, apparatuses, and method may be implemented in other ways. For example, the foregoing apparatus embodiments are only for illustration. For example, the division of the units is based only on logical functionality. In actual implementation, another division manner may be available, for example, multiple units or components may be combined or integrated into another system, or some features may be ignored or not be executed. In addition, the displayed or discussed mutual couplings or direct couplings or communication connections may be implemented through some interfaces. The indirect couplings or communication connections between the apparatuses or units may be implemented in electrical, mechanical or another manner.

The units that are described as separate components may or may not be physically separate. The components that are displayed as the units may or may not be physical units, that is, the components may be located at one place or distributed on multiple network elements. Some or all of the units may be selected according to an actual requirement to achieve the objectives of the solutions of the embodiments.

In addition, each functional unit in the embodiments of the present invention may be integrated into a processing unit, or may exist independently and physically, or two or more units are integrated into one unit. The integrated unit may be implemented in the form of hardware or a software functional unit in addition to hardware.

The integrated unit implemented in the form of a software functional unit may be stored in a computer readable storage medium. The software functional unit is stored in a storage medium, and incorporates several instructions to instruct a computer device (such as a personal computer, a server, or a network device) to execute a part of the steps in the method described in each of the embodiments of the present invention. The preceding storage medium may include any medium that is capable of storing program codes, such as a USB disk, a removable hard disk, a read-only memory (Read-Only Memory, ROM), a random access memory (Random Access Memory, RAM), a magnetic disk, or a CD-ROM.

Finally, it should be noted that the embodiments of the present invention are intended only for describing the technical solutions of the present invention rather than limiting the present invention. Although the present invention is described in detail with reference to the foregoing embodiments, persons of ordinary skill in the art should understand that they can still make modifications to the technical solutions described in the foregoing embodiments or make substitutions to some technical features thereof, without departing from the spirit and scope of the technical solutions of the embodiments of the present invention.

## Claims

1. A method for simulating multiple processors in parallel, comprising:
creating, by a scheduler, one or more slave threads using a master thread, and determining and obtaining a processor that is simulated by the master thread and a processor that is simulated by a slave thread; and
using, by the scheduler, the master thread and the one or more slave threads to invoke, through a first execute interface, the determined processor that is simulated by the master thread and the determined processor that is simulated by the slave thread to execute a corresponding instruction, wherein the first execute interface is registered with the scheduler by the determined processor that is simulated by the master thread and the determined processor that is simulated by the slave thread.

2. The method according to claim 1, wherein the instruction comprises at least one of the following instructions:
an instruction for accessing memory, which is used for indicating an instruction for accessing a same type of memory or different types of memory; and
an instruction for accessing a peripheral, which is used for indicating an instruction for accessing a same peripheral or different peripherals.

3. The method according to claim 1, wherein the instruction is an atomic instruction and the invoking, by the scheduler, the determined processor that is simulated by the master thread and the determined processor that is simulated by the slave thread to execute a corresponding instruction comprises:
using, by the scheduler, a mutex lock operation to invoke the determined processor that is simulated by the master thread and the determined processor that is simulated by the slave thread to execute the corresponding instruction.

4. The method according to claim 1, further comprising:
using, by the scheduler, the master thread and the one or more slave threads to assign, through a first cycle interface, a cycle parameter to the determined processor that is simulated by the master thread and the determined processor that is simulated by the slave thread, in order to control synchronous invoking between the determined processor that is simulated by the master thread and the determined processor that is simulated by the slave thread, wherein the first cycle interface is registered with the scheduler by the determined processor that is simulated by the master thread and the determined processor that is simulated by the slave thread.

5. The method according to any one of claims 1-4, wherein the scheduler is a scheduling unit in a SIMICS simulator.

6. The method according to any one of claims 1-4, further comprising:
registering, by the scheduler, a corresponding second execute interface with a scheduling unit in a SIMICS simulator, so that the scheduling unit triggers, through the second execute interface, the scheduler to create one or more slave threads using the master thread.

7. The method according to claim 6, further comprising:
registering, by the scheduler, a corresponding second cycle interface with the scheduling unit in the SIMICS simulator, so that the scheduling unit uses the master thread to assign a cycle parameter to the scheduler through the second cycle interface, and thereby the scheduler uses the master thread and the one or more slave threads to assign, through the first cycle interface, the cycle parameter to the determined processor that is simulated by the master thread and the determined processor that is simulated by the slave thread, in order to control synchronous invoking between the determined processor that is simulated by the master thread and the determined processor that is simulated by the slave thread, wherein the first cycle interface is registered with the scheduler by the determined processor that is simulated by the master thread and the determined processor that is simulated by the slave thread.

8. A scheduler, comprising:
a creating unit, configured to create one or more slave threads using a master thread, and determine and obtain a processor that is simulated by the master thread and a processor that is simulated by a slave thread; and
an invoking unit, configured to use the master thread and the one or more slave threads that are created by the creating unit to invoke, through a first execute interface, the processor that is simulated by the master thread and determined by the creating unit and the processor that is simulated by the slave thread and determined by the creating unit to execute a corresponding instruction, wherein the first execute interface is registered with the scheduler by the determined processor that is simulated by the master thread and the determined processor that is simulated by the slave thread.

9. The scheduler according to claim 8, wherein the corresponding instruction that the invoking unit invokes the processor that is simulated by the master thread and determined by the creating unit and the processor that is simulated by the slave thread and determined by the creating unit to execute comprises at least one of the following instructions:
an instruction for accessing memory, which is used for indicating an instruction for accessing a same type of memory or different types of memory; and
an instruction for accessing a peripheral, which is used for indicating an instruction for accessing a same peripheral or different peripherals.

10. The scheduler according to claim 8, wherein the corresponding instruction that the invoking unit invokes the processor that is simulated by the master thread and determined by the creating unit and the processor that is simulated by the slave thread and determined by the creating unit to execute is an atomic instruction, and the invoking unit is specifically configured to:
use a mutex lock operation to invoke the processor that is simulated by the master thread and determined by the creating unit and the processor that is simulated by the slave thread and determined by the creating unit to execute the corresponding instruction.

11. The scheduler according to claim 8, wherein the invoking unit is further configured to
use the master thread and the one or more slave threads to assign, through a first cycle interface, a cycle parameter to the determined processor that is simulated by the master thread and the determined processor that is simulated by the slave thread, in order to control synchronous invoking between the determined processor that is simulated by the master thread and the determined processor that is simulated by the slave thread, wherein the first cycle interface is registered with the scheduler by the determined processor that is simulated by the master thread and the determined processor that is simulated by the slave thread.

12. The scheduler according to any one of claims 8-11, wherein the scheduler is a scheduling unit in a SIMICS simulator.

13. The scheduler according to any one of claims 8-11, wherein the scheduler further comprises a registering unit, configured to
register a corresponding second execute interface with a scheduling unit in a SIMICS simulator, so that the scheduling unit triggers, through the second execute interface, the scheduler to create one or more slave threads using the master thread.

14. The scheduler according to claim 13, wherein the registering unit is further configured to
register a corresponding second cycle interface with the scheduling unit in the SIMICS simulator, so that the scheduling unit uses the master thread to assign a cycle parameter to the scheduler through the second cycle interface, and thereby the invoking unit uses the master thread and the one or more slave threads to assign, through the first cycle interface, the cycle parameter to the determined processor that is simulated by the master thread and the determined processor that is simulated by the slave thread, in order to control synchronous invoking between the determined processor that is simulated by the master thread and the determined processor that is simulated by the slave thread, wherein the first cycle interface is registered with the scheduler by the determined processor that is simulated by the master thread and the determined processor that is simulated by the slave thread.

15. A system for simulating multiple processors in parallel, comprising a processor that is simulated by a master thread and a processor that is simulated by a slave thread, and further comprising the scheduler according to any one of claims 8-14.
